# EUROPÄISCHE PATENTSCHRIFT

(11) **EP 0 732 594 B1**
(45) Veröffentlichungstag und Bekanntmachung des Hinweises auf die Patenterteilung: **25.11.1998**
(21) Anmeldenummer: 96103569.8
(22) Anmeldetag: 07.03.1996
(51) Int. Cl.: G01P 15/08, G01P 1/02

(54) **Verfahren zur Herstellung mikromechanischer Bauelemente**
Fabrication method for micromechanical semiconductor devices
Procédé de fabrication de dispositifs semi-conducteurs micromécaniques

(30) Priorität: 17.03.1995 DE 19509868
(43) Veröffentlichungstag der Anmeldung: 18.09.1996
(73) Patentinhaber: SIEMENS AKTIENGESELLSCHAFT, 80333 München (DE)
(72) Erfinder: Hierold, Christofer, Dr., 81739 München (DE); Scheiter, Thomas, 80469 München (DE); Biebl, Markus, 86163 Augsburg (DE); Klose, Helmut, Dr., 81929 München (DE)

(56) Entgegenhaltungen:
- EP-A- 0 679 878
- US-A- 5 164 328
- US-A- 5 258 097
- US-A- 5 324 683
- SENSORS AND ACTUATORS, Bd. A45, Nr. 1, Oktober 1994, LAUSANNE, CH, Seiten 7-16, XP000444705 W. KUEHNEL ET AL: "A surface micromachined silicon accelerometer with on-chip detection circuitry"
- SENSORS AND ACTUATORS, Bd. A41, Nr. 1/3, 1.April 1994, LAUSANNE, CH, Seiten 129-135, XP000450022 B. PUERS ET AL: "Extremely miniaturized capacitive movement sensors using new suspension systems"
- PATENT ABSTRACTS OF JAPAN vol. 94, no. 010 & JP-A-06 283528 (MATSUSHITA ELECTRIC IND CO LTD), 7.Oktober 1994,

## Beschreibung

Die vorliegende Erfindung betrifft Herstellungsverfahren für mikromechanische Bauelemente, z. B. Beschleunigungssensoren.

Mikromechanische Bauelemente, die als Sensoren oder Aktuatoren eingesetzt werden sollen, benötigen mikromechanische Komponenten, die beweglich auf einer Oberseite des Halbleitersubstrates angebracht sind. Um ihre Funktion erfüllen zu können, müssen diese beweglichen Komponenten gegen äußere Einflüsse ausreichend geschützt werden, weshalb derartige Bauelemente z. B. in ein Gehäuse eingesetzt werden. Es ist nicht möglich, die Bauelemente wie elektronische integrierte Schaltungen in Kunststoff z. B. nach einem Spritzgußverfahren einzubetten. Beschleunigungssensoren wurden bisher in teure Metall- oder Keramikgehäuse verpackt. Die Kosten des Systems werden in diesem Fall im wesentlichen von den Kosten des Gehäuses und der Montage bestimmt.

In der US 5,324,683 ist ein Verfahren beschrieben, mit dem ein Hohlraum zur verbesserten dielektrischen Abschirmung von Leiterbahnen oder zur Aufnahme von Mikrostrukturen hergestellt wird. Eine Schicht aus Metall, Silizium oder einem Dielektrikum mit einer Aussparung wird mit einer selektiv dazu ätzbaren Schicht überdeckt. Diese Schicht wird zu Distanzstreifen (spacer) am Rand der Aussparung rückgeätzt. Der verbleibende Teil der Aussparung wird mit einem Dielektrikum aufgefüllt, die Spacer werden entfernt, und eine Schichtfolge aus Dielektrikum wird zum Verschließen des Hohlraumes aufgebracht.

In der US 5,164,328 ist ein Verfahren zum Anbringen eines mikromechanischen Beschleunigungssensors auf einem IC-Chip beschrieben, bei dem ein Substrat mit einem beweglichen Masseteil mittels kleiner Säulen aus Lot, die auch den elektrischen Anschluß des Sensors bilden, invers auf dem IC-Chip befestigt und der Zwischenraum zwischen dem Substrat und dem Chip ringsum mit einem Dielektrikum verschlossen wird.

Aufgabe der vorliegenden Erfindung ist es, ein vereinfachtes Herstellungsverfahren für mikromechanische Bauelemente anzugeben, die auf einfache Weise mit elektronischen Komponenten, insbesondere im Rahmen eines CMOS-Prozesses, integriert und in einem Gehäuse montiert werden können.

Diese Aufgabe wird mit dem Verfahren mit den Merkmalen des Anspruches 1 gelöst. Ausgestaltungen ergeben sich aus den abhängigen Ansprüchen.

Die vorliegende Erfindung ermöglicht es, ein bewegliches mikromechanisches Element (z. B. ein Masseteil, Cantilever o. dgl.) in einem Hohlraum mit druckstabiler Abdeckung auf der Oberseite des Substrates anzuordnen. Das Bauelement mit der Abdeckung des mikromechanischen Elementes ist in den oberen Strukturschichten des Chips ausgebildet und kann im Rahmen des Herstellungsprozesses hergestellt werden, der auch für die Herstellung weiterer Bauelemente, z. B. von elektronischen Ansteuerkomponenten oder mikromechanischen Sensoren/Aktuatoren, vorgesehen ist. Das bewegliche Element wird über der Oberseite eines Substrates oder einer Schichtstruktur aus Halbleitermaterial hergestellt. Auf der dem Substrat oder der Schichtstruktur abgewandten Seite des vorzugsweise schichtartig ausgebildeten beweglichen Elementes wird eine Abdeckungsschicht hergestellt, die auf pfeilerartigen Stützen oder Stegen auf der Substratoberfläche abgestützt ist. Zwischen dieser Abdeckungsschicht und dem Substrat befindet sich ein Hohlraum, der so bemessen wird, daß das bewegliche Element sich in dem für seine Funktion vorgesehenen Ausmaß bewegen kann. Die für das Abstützen dieser Abdeckungsschicht vorgesehenen pfeiler- oder säulenartigen Stützen können auch im Bereich des beweglichen Elementes vorgesehen werden. In dem beweglichen Element werden dann entsprechende Löcher oder Aussparungen hergestellt (z. B. ausgeätzt), die so groß sind, daß die Stützen nicht nur hindurchpassen, sondern auch die erforderliche Beweglichkeit des beweglichen Elementes nicht beeinträchtigt ist. Es kann sich daher in dem Hohlraum ein ganzes Raster aus einzelnen Stützen für die Abdeckungsschicht befinden.

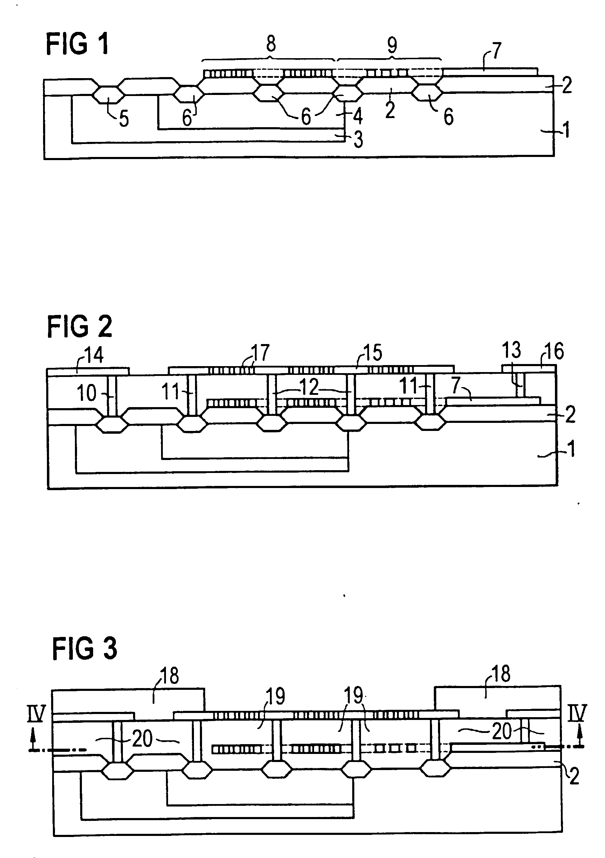

Eine einfache Herstellbarkeit dieser Anordnung ergibt sich daraus, daß für die Stützen Kontaktlochauffüllungen verwendet werden können. In einer Schicht, die z. B. aus einem Dielektrikum besteht, werden Kontaktlöcher für elektrischen Anschluß einzelner Komponenten der Bauelemente hergestellt. Diese Kontaktlöcher werden wie üblich mit dem für die Metallisierung vorgesehenen Metall aufgefüllt. In entsprechender Weise können an den für die Stützen oder Pfeiler vorgesehenen Stellen ebenfalls Löcher nach Art dieser Kontaktlöcher in dieser Dielektrikumschicht hergestellt werden, was sogar in demselben Prozeßschritt erfolgen kann. Es kann dasselbe Material, das für die Kontaktlochfüllungen vorgesehen ist, auch für die Stützen der Abdeckungsschicht verwendet werden. Nach dem Entfernen der Dielektrikumschicht in dem für das bewegliche Element vorgesehenen Bereich ergibt sich die Beweglichkeit dieses Teiles in dem auf diese Weise hergestellten Hohlraum zwischen dem Substrat und der Abdeckungsschicht. Die Herstellung des Bauelementes kann daher auf einfache Weise in einen Prozeß integriert werden, der für die Herstellung elektronischer Bauelemente vorgesehen ist. Zur Erläuterung der Erfindung dienen die folgenden Ausführungsbeispiele, die anhand der Figuren 1 bis 11 im einzelnen beschrieben werden.
- Figuren 1 bis 3: zeigen Zwischenprodukte des Bauelementes nach verschiedenen Schritten des Herstellungsverfahrens im Querschnitt.
- Figur 4: zeigt den in Figur 3 eingezeichneten Schnitt.
- Figur 5: zeigt ein erfindungsgemäß hergestelltes Bauelement im Querschnitt.
- Figur 6: zeigt einen Querschnitt eines erfindungsgemäß hergestellten Bauelementes zur Erläuterung eines alternativen Schrittes des Herstellungsverfahrens.
- Figuren 7 bis 10: zeigen verschiedene Strukturen von beweglichen Komponenten, die für einen erfindungsgemäß hergestellten Beschleunigungssensor besonders geeignet sind.
- Figur 11: zeigt eine alternative Ausführungsform des erfindungsgemäß hergestellten Bauelementes im Querschnitt.

In Figur 1 ist ein Substrat 1, das z. B. Silizium sein kann, eingezeichnet. In der folgenden Beschreibung und in den Ansprüchen ist unter Substrat allgemein eine Halbleiterscheibe oder eine Halbleiterschichtstruktur zu verstehen. Auf diesem Substrat 1 wird eine Hilfsschicht 2 hergestellt. Die Hilfsschicht 2 kann eine eigens aufgebrachte Schicht sein oder durch einen an der Oberseite des Substrates 1 befindlichen Schichtanteil gebildet werden. Falls das Substrat Silizium ist, wird die Hilfsschicht 2 zweckmäßig durch lokale Oxidation eines oberen Schichtanteiles des Siliziums hergestellt (LOCOS). Von dieser Oxidation werden Bereiche ausgenommen, die z. B. unter Verwendung einer Maske abgeschirmt werden. Im Bereich des herzustellenden beweglichen Elementes wird die Strukturschicht 7, die für die Herstellung dieses beweglichen Elementes vorgesehen ist, abgeschieden. Diese Strukturschicht 7 kann z. B. kristallines Silizium oder Polysilizium sein und z. B. gleichzeitig mit einer Siliziumschicht abgeschieden werden, die für Elektroden elektronischer Bauelemente, die zusammen mit dem mikromechanischen Bauelement integriert werden, vorgesehen ist.

Bei dem hier beschriebenen Ausführungsbeispiel werden in dem Substrat 1 dotierte Bereiche ausgebildet, wie sie z. B. im Fall eines Beschleunigungssensors erwünscht sein können. Das Substrat 1 und die eingezeichneten Isolierungsbereiche 6 werden für elektrische Leitfähigkeit eines ersten Leitfähigkeitstyps dotiert. Die eingezeichneten dotierten Bereiche 3 und 4 und der an den unteren dotierten Bereich 3 anschließende Kontaktbereich 5 werden für elektrische Leitung des gegenüber dem Substrat entgegengesetzten Vorzeichens dotiert. Der obere Bereich 4 ist als Gegenelektrode zu dem elektrisch leitend herzustellenden beweglichen Sensorelement vorgesehen. Der Kontaktbereich 5 und der untere Bereich 3 werden vorzugsweise höher dotiert als der Elektrodenbereich 4. Der untere Bereich 3 wird z. B. als vergrabene Schicht (n⁺ buried layer), der Elektrodenbereich 4 als n-Wanne und der Kontaktbereich 5 als n⁺-Anschlußimplantation ausgebildet. Die Isolierungsbereiche 6 isolieren die darauf aufzubringenden Strukturen von diesem Elektrodenbereich 4. Bei alternativen Ausführungsformen, d. h. für Bauelemente, die anders strukturiert oder für andere Funktionen vorgesehen sind, können die dotierten Bereiche im Substrat weggelassen oder anders strukturiert werden. Nachdem die Strukturschicht 7 aufgebracht ist, wird sie strukturiert, wobei das für den Sensor vorgesehene und mit einer Vielzahl von Ätzlöchern versehene bewegliche Element 8, die für die Befestigung dieses Elementes vorgesehenen federartigen Verstrebungen 9 und der für die Befestigung auf dem Substrat und für den elektrischen Anschluß vorgesehene Anteil hergestellt werden. Über den Isolierungsbereichen 6, die in Aussparungen der Hilfsschicht 2 vorhanden sind, wird die Strukturschicht 7 entfernt.

Auf die Oberseite wird dann ganzflächig eine planarisierende weitere Hilfsschicht, z. B. aus einem Dielektrikum, aufgebracht. Das Material dieser weiteren Hilfsschicht wird so gewählt, daß es sich selektiv gegenüber dem Material der Strukturschicht 7 z. B. durch Ätzen entfernen läßt. In dieser weiteren Hilfsschicht werden die Öffnungen für Kontakte und für die vorgesehenen pfeilerartigen Stützen oder Stege hergestellt. Diese Öffnungen werden dann mit dem dafür vorgesehenen Material aufgefüllt. Vorteilhaft ist es, wenn für Kontaktlochfüllungen und für die Stege oder Stützen dasselbe Metall verwendet wird. Auf diese Weise wird die für den elektrischen Anschluß des Elektrodenbereiches 4 vorgesehene Kontaktlochfüllung 10 (s. Figur 2), die für den elektrischen Anschluß des elektrisch leitenden (ggf. elektrisch leitend dotierten, z. B. bei Silizium) beweglichen Elementes vorgesehene Kontaktlochfüllung 13 und die für die Abstützung der Abdeckungsschicht vorgesehenen Stege 11 bzw. pfeilerartigen Stützen 12 hergestellt.

Dann kann die für den elektrischen Anschluß vorgesehene erste Metallisierungsebene aufgebracht werden, die in diesem Ausführungsbeispiel aus einem auf der Kontaktlochfüllung 10 aufgebrachten Anteil 14, aus einem auf der Kontaktlochfüllung 13 aufgebrachten weiteren Anteil 16 und aus der Abdeckungsschicht 15 besteht. Die Abdeckungsschicht kann alternativ aus Halbleitermaterial, z. B. Silizium, hergestellt werden oder aus einem von dieser ersten Metallisierungsebene verschiedenen Metall. Vorteilhaft ist es aber zur Vereinfachung des Herstellungsprozesses, wenn für die Abdeckungsschicht das Metall der ersten Metallisierungsebene, die für den elektrischen Anschluß der integrierten elektronischen Komponenten oder für Leiterbahnen vorgesehen ist, verwendet wird. In der Abdeckungsschicht 15 werden wie in Figur 2 angedeutet viele kleine Ätzlöcher 17 ausgeätzt. Die Strukturschicht 7 weist im Bereich des herzustellenden beweglichen Elementes 8 ebenfalls bei der Strukturierung hergestellte Löcher auf, die als Ätzöffnungen vorgesehen sind. Unter Verwendung dieser Ätzöffnungen in der Strukturschicht 7 und der Abdeckungsschicht 15 kann dann das Material der Hilfsschicht und der weiteren Hilfsschicht im Bereich zwischen dem Substrat 1 und der Abdeckungsschicht 15 selektiv gegenüber dem Material der Strukturschicht 7 soweit entfernt werden, daß der für das bewegliche Teil vorgesehene Anteil der Strukturschicht 7 freigelegt ist. Vorteilhaft ist es, wenn die Stege 11, die für die Abstützung der Abdeckungsschicht 15 vorgesehen sind, rings um den herzustellenden Hohlraum herum vorhanden sind, so daß bei dem Freiätzen des beweglichen Elementes 8 das Material der weiteren Hilfsschicht, das sich im Bereich außerhalb des herzustellenden Hohlraumes befindet, durch diesen umlaufenden Steg 11 geschützt ist.

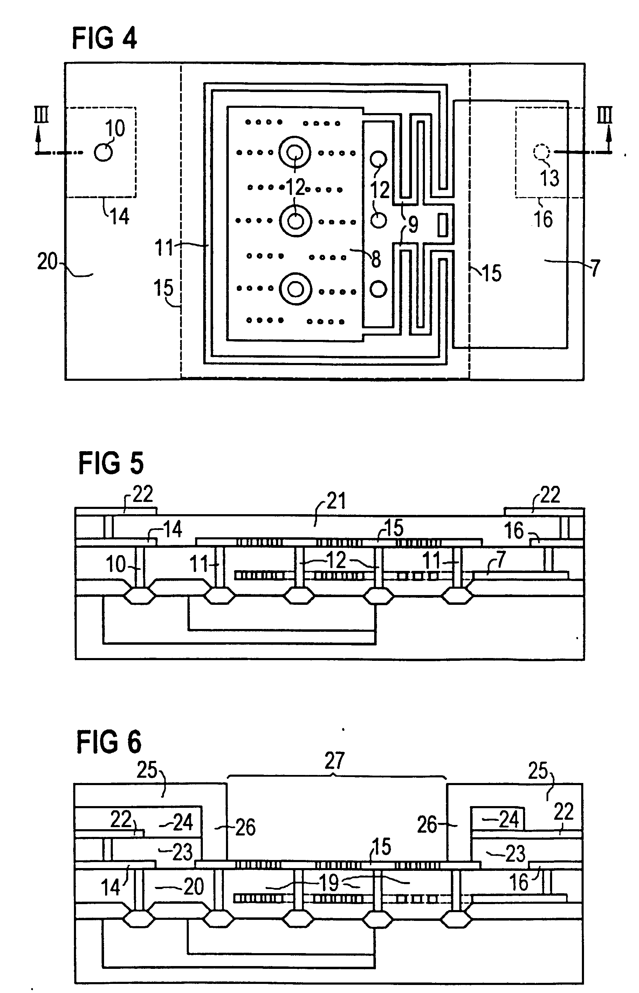

Beim Ätzen des Hohlraumes unter der Abdeckungsschicht können die übrigen Bereiche durch eine Maske 18 geschützt werden, wie in Figur 3 eingezeichnet ist. Man erhält so den an den seitlichen Wänden durch die Stege 11 begrenzten Hohlraum 19 zwischen dem Substrat und der Abdeckungsschicht. Die übrig bleibenden Anteile der Hilfsschicht 2 und der weiteren Hilfsschicht 20 sind jetzt nur noch seitlich zu diesem Hohlraum 19 vorhanden. Zur Verdeutlichung sind in den Zeichnungen die aus der Zeichenebene nach hinten versetzten Begrenzungen der Strukturschicht 7 gestrichelt eingezeichnet. Der in Figur 3 eingezeichnete Schnitt in der Schichtebene der Strukturschicht, in der jetzt das bewegliche Element hergestellt ist, ist in Figur 4 gezeichnet.

In Figur 4 ist die Strukturschicht 7 mit dem beweglichen Element 8 und den hier mäandrierend strukturierten Verstrebungen 9 eingezeichnet. In dem beweglichen Element 8 sind die Ätzlöcher durch kleine Kreise angedeutet. Die pfeilerartigen Stützen 12 zur Abstützung der Abdeckungsschicht sind in Aussparungen des beweglichen Elementes 8 und zwischen diesem Element 8 und den Verstrebungen 9 angeordnet. Stege 11 sind rings um das bewegliche Element und die Verstrebungen herum vorhanden und nur für die Verbindung dieser Verstrebungen 9 mit dem auf dem Substrat befestigten Anteil der Strukturschicht 7 durchbrochen. Die Kontaktlochfüllung 10 in der Ebene der Strukturschicht 7 ist ebenfalls eingezeichnet. Als verdeckte Konturen gestrichelt eingezeichnet sind die Kontaktlochfüllung 13, die Anteile 14, 16 der ersten Metallisierungsebene und der Rand der Abdeckungsschicht 15. Im Bereich zwischen den Stegen 11 und den Anteilen der Strukturschicht 7 ist wegen des vorhandenen Hohlraumes in dem in Figur 4 gezeichneten Schnitt die Abdeckungsschicht 15 sichtbar. Es wurde der Übersichtlichkeit halber darauf verzichtet, die in der Abdeckungsschicht 15 vorhandenen Ätzlöcher in diesem Bereich ebenfalls einzuzeichnen.

Bei einem erfindungsgemäß hergestellten Beschleunigungssensor kann die Abdeckungsschicht aus Metall oder einem elektrisch leitfähig dotierten Halbleitermaterial als obere Gegenelektrode zu dem ebenfalls elektrisch leitenden beweglichen Element fungieren. Die Abdeckungsschicht 15 wird dann z. B. aus Metall hergestellt oder zumindest stellenweise elektrisch leitend dotiert und mit einem elektrischen Anschluß, der in den Figuren nicht eingezeichnet ist, versehen. Ein fertiges Bauelement ist im Querschnitt in Figur 5 gezeigt, bei dem die Abdeckungsschicht 15 nach oben von einer Verschlußschicht 21 bedeckt ist. Diese Verschlußschicht 21 schließt auch die in der Abdeckungsschicht 15 vorhandenen Ätzlöcher. In der Verschlußschicht, die z. B. wieder ein Dielektrikum sein kann, können erneut Kontaktlöcher hergestellt und mit Metallisierungen gefüllt werden. Eine weitere Metallisierungsebene 22 kann auf der Oberseite aufgebracht werden. Weitere ergänzende Schichtstrukturen können dann noch auf der Oberseite hergestellt werden.

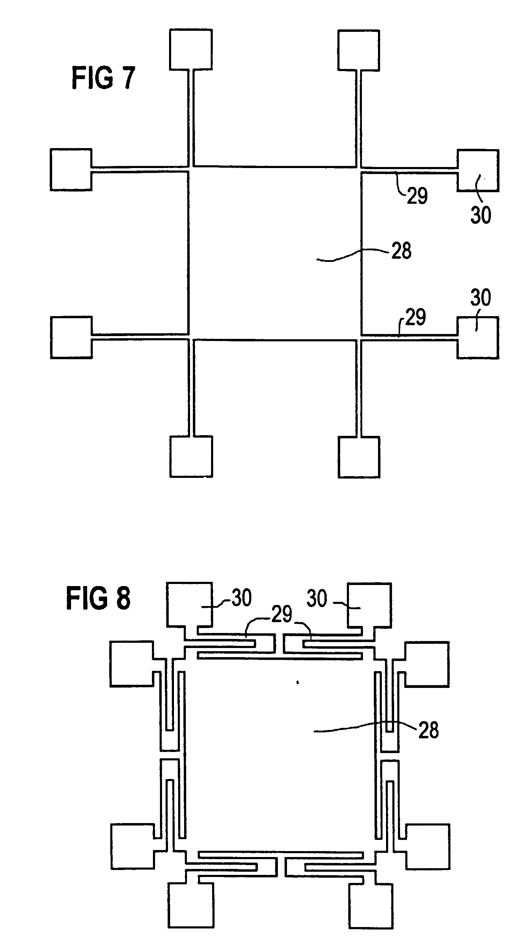

Das Ausätzen des Hohlraumes 19 kann auch erfolgen, nachdem weitere Metallisierungsebenen auf dem Bauelement aufgebracht sind. In Figur 6 ist eine solche Struktur dargestellt, bei der eine Dielektrikumschicht 23, eine weitere Metallisierungsebene 22 und eine weitere Dielektrikumschicht 24 auf der Oberseite des Bauelementes hergestellt sind, um z. B. die vorgesehenen elektrischen Verbindungen der verschiedenen in dem Chip integrierten Bauelemente herzustellen. Diese Schichtstruktur auf der Oberseite der Abdeckungsschicht 15 kann dann im Bereich des freizuätzenden beweglichen Elementes entfernt werden, so daß in der eingezeichneten Öffnung 27 die Oberfläche der Abdeckungsschicht 15 freigelegt ist. Das Ätzen der Öffnung 27 geschieht zweckmäßig unter Verwendung einer Maske 25, die in dem in Figur 6 gezeigten Beispiel über laterale Anteile 26 verfügt, die bei einem Ätzschritt zum Herstellen des Hohlraumes 19 die Dielektrikumschichten 23, 24 auf der Oberseite des Bauelementes gegen den Ätzangriff schützen. Die Verwendung von Maskentechnik und die Justage der verschiedenen zu verwendenden Masken können in der an sich bekannten Weise erfolgen.

Wie aus der Beschreibung des Herstellungsverfahrens dieses Ausführungsbeispiels hervorgeht, können die Verfahrensschritte im Rahmen eines CMOS-Prozesses erfolgen. Falls z. B. eine für Gateelektroden von MOSFETs vorgesehene Oxidschicht auch im Bereich des mikromechanischen Bauelementes hergestellt wird, kann diese Oxidschicht zusammen mit der Hilfsschicht beim Ausätzen des Hohlraumes problemlos entfernt werden. Für die Strukturschicht 7 kann z. B. eine etwa 400 nm dicke Polysiliziumschicht abgeschieden werden, wie sie auch für die Gateelektroden von Transistoren verwendet wird. Die Hilfsschicht 2 wird z. B. wie beschrieben durch Oxidieren von Silizium (Feldoxid) in einer typischen Dicke von z. B. 650 nm hergestellt.

Neben dem für das mikromechanische Bauelement vorgesehenen Bereich können gleichzeitig elektronische Bauelemente, wie z. B. Transistoren, Kapazitäten, Widerstände und dergleichen hergestellt werden. Die Metallisierung, aus der in dem Beispiel auch die Abdeckungsschicht 15 hergestellt wird, hat z. B. eine typische Dicke von 0,5 µm bis 1,5 µm. Als Metall für die Kontaktlochfüllung kann z. B. AlSiCu oder Wo verwendet werden. Diese Metalle und Legierungen können auch für die Metallisierungsebene (Leiterbahn) verwendet werden, wobei es vorteilhaft ist, wenn für die Stützen und Stege Wo und für die Metallisierungsebene AlSiCu verwendet wird. Es vereinfacht die Herstellung und ist daher zweckmäßig, wenn für die Kontaktlochfüllung und die Metallisierungsebene dasselbe Metall verwendet wird. Es kann zusätzlich eine Barriere zwischen dem Metall der Kontaktlochfüllungen, das vorteilhaft z. B. auch die Stützen und Stege zum Abstützen der Abdeckungsschicht bildet, und dem Halbleitermaterial des Substrates (Kontaktbereich 5 und Isolierungsbereich 6 aus Silizium in dem Beispiel) vorgesehen werden. Eine solche Barriere besteht z. B. aus einer dünnen Schicht aus Ti oder TiN oder einer Schichtfolge aus Ti und TiN in einer Dicke von typisch 5 nm bis 200 nm. Damit wird ein Ausdiffundieren des Metalles in das Silizium verhindert.

Vorteilhaft ist das Aufbringen einer dünnen Barriereschicht vorteilhaft z. B. aus den genannten Metallen auf der Oberseite der Abdeckungsschicht. Die Ätzlöcher 17 werden dann auch in dieser Barriereschicht hergestellt. Die Barriereschicht schützt das Material der Abdeckungsschicht (z. B. Metall) bei dem nachfolgenden Ausätzen des Hohlraumes 19.

Für die in Figur 3 eingezeichnete Maske 18 kann z. B. Fotolack, ein Nitrid (z. B. Siliziumnitrid) oder eine Schichtfolge aus einem Nitrid und Fotolack verwendet werden. Grundsätzlich kommen für diese Maske beliebige Materialien in Frage, die gegen das zu verwendende Ätzmittel für das Ausätzen der weiteren Hilfsschicht resistent sind. Die angegebenen Materialien für die Maske 18 sind verwendbar, wenn als weitere Hilfsschicht eine Oxidschicht (z. B. Siliziumoxid) verwendet wird.

Das Ätzmittel, das die Hilfsschicht und die weitere Hilfsschicht selektiv gegenüber dem Material des Substrates und dem Material der Abdeckungsschicht entfernt, kann im Fall der Verwendung von Siliziumoxid für die Hilfsschichten, von Silizium für das bewegliche Element und von Metall für die Abdeckungsschicht z. B. Fluorwasserstoff (HF) sein. Fluorwasserstoff kann entweder naßchemisch als Flußsäure oder gepufferte Flußsäure eingesetzt werden oder als Fluorwasserstoffgas oder -dampf. Bei einer Verwendung von AlSiCu für die Metallisierung kann bei naßchemischem Ätzen die Flußsäure mit Zusätzen versehen werden, die die Selektivität der Ätzung gegen Aluminium erhöhen. Bei Verwendung einer gepufferten Flußsäurelösung (BOE, Buffered Oxide Etch) kann ebenfalls mit Zusätzen die Selektivität gegen Aluminium erhöht werden. Vorteilhaft ist die Verwendung von Fluorwasserstoffgas, wenn eine möglichst gute Selektivität gleichzeitig gegenüber dem Silizium der Strukturschicht und dem Metall der Abdeckungsschicht erreicht werden soll. Eine Abdeckungsschicht aus Metall kann wie erwähnt durch Aufbringen einer dünnen Barriereschicht aus Metall, das gegen das Ätzmittel resistenter ist, zusätzlich gegen den Ätzangriff geschützt werden.

Für die Verschlußschicht 21, mit der die Ätzöffnungen 17 in der Abdeckungsschicht 15 verschlossen werden und die bei Ausführungen, in denen sie aus einem Dielektrikum hergestellt wird, auch als Isolierungsschicht zwischen verschiedenen Metallisierungsebenen verwendet werden kann, kommt vorteilhaft Siliziumoxid oder Siliziumnitrid in Frage. Diese Verschlußschicht kann z. B. aus einem Plasma abgeschieden werden.

Das erfindungsgemäß hergestellte Bauelement kann grundsätzlich für beliebige Funktionen vorgesehen sein. Eine druckstabile Abdeckungsschicht für das bewegliche Teil ist verwendbar für Sensoren und Aktuatoren praktisch beliebiger Ausgestaltung. Wenn auf die Verschlußschicht entweder verzichtet wird oder in der Abdeckungsschicht und in ggf. darauf vorhandenen weiteren Schichten Löcher oder Öffnungen vorhanden sind, die eine gitterartige oder siebartige Struktur bilden, kann diese Abdeckung z. B. auch für Drucksensoren verwendet werden. Die Erfindung ist daher realisierbar für beliebige Bauelemente, bei denen ein spezielles Funktionselement gegen mechanische äußere Einflüsse geschützt werden muß. Das Bauelement kann dann in einem Standardgehäuse montiert werden, ohne daß weitere Maßnahmen erforderlich sind. Weitere Anwendungsmöglichkeiten ergeben sich für die Herstellung von Winkelgeschwindigkeitsmessern oder mikromechanische Schwinger, wie z. B. Resonatoren oder Filter, die lateral oder vertikal bezüglich des Substrates schwingen.

Besondere Vorteile bietet eine elektrisch leitende Abdeckungsschicht im Fall eines Beschleunigungssensors, da diese Abdeckungsschicht dann als Gegenelektrode eingesetzt werden kann. Eine Gegenelektrode auf der Seite des Substrates wird dann z. B. durch einen dotierten Bereich, wie er in dem Ausführungsbeispiel als Elektrodenbereich 4 beschrieben wurde, gebildet. Jede dieser beiden Gegenelektroden über und unter dem beweglichen Element bildet dann zusammen mit diesem Element jeweils einen Kondensator, dessen Kapazität sich ändert, wenn das bewegliche Teil in einer Richtung senkrecht zur Substratoberfläche ausgelenkt wird. Die Änderungen dieser Kapazitäten können bestimmt werden, indem Spannungen zwischen dem beweglichen Element und jeweils einer Gegenelektrode angelegt werden und die bei einer auftretenden Änderung der Kapazität fließenden Ströme in einer Auswerteeinheit zur Bestimmung der Kapazität verwendet werden. Es ist außerdem möglich, durch eine entsprechende Änderung der anliegenden Spannungen elektrostatisch eine Auslenkung des beweglichen Teiles zu verhindern und gleichzeitig aus der Höhe der dafür erforderlichen Spannungsänderung die einwirkende Trägheitskraft zu bestimmen. Für einen derartigen Beschleunigungssensor ist daher das erfindungsgemäße Herstellungsverfahren besonders geeignet, da die druckstabile Abdeckungsschicht gleichzeitig als obere Gegenelektrode eingesetzt werden kann.

Der Abstand zwischen der Oberseite des Substrates und der Abdeckungsschicht, also die Höhe des Hohlraumes 19, sollte nicht zu groß bemessen sein, um eine ausreichende mechanische Stabilität der durch die Abdeckungsschicht und die Stege 11 bzw. Stützen 12 gebildeten Anordnung zu gewährleisten. Ein erfindungsgemäß hergestellter Beschleunigungssensor sollte daher so beschaffen sein, daß in dem vorgesehenen Meßbereich die Auslenkungen des beweglichen Teiles in vertikaler Richtung möglichst klein gehalten werden. Für eine kapazitive Auswertung von Auslenkungen des beweglichen Teiles als Folge einer einwirkenden Trägheitskraft ist es wünschenswert, wenn sich das schichtartig ausgebildete bewegliche Teil möglichst wenig verformt und nach Möglichkeit eben bleibt. Dafür ist es zweckmäßig, wenn die Verstrebungen 9 so gestaltet werden, daß eine möglichst weiche Aufhängung des Elementes 8 gegeben ist. Die federnde Wirkung der Verstrebungen 9 sollte daher möglichst groß sein (kleine "Federkonstante"). Bei einer wenig straffen, also weichen Aufhängung des beweglichen Elementes 8 kann das Element, auch wenn es aus einer sehr dünnen Schicht besteht, als Ganzes weitgehend verformungsfrei auf- und abschwingen. Eine weiche Aufhängung des Elementes 8 ergibt außerdem eine relativ hohe Empfindlichkeit des Sensors. Eine derartige Aufhängung wird am besten erreicht, indem die Verstrebungen 9 mäandrierend strukturiert werden.

In den Figuren 7 bis 10 sind Beispiele für die Strukturierung der Strukturschicht 7 in Aufsicht dargestellt. Das bewegliche Element 28 ist jeweils an Verstrebungen 29 befestigt, die ihrerseits an Aufhängeflächen 30 befestigt sind. Diese Aufhängeflächen 30 sind fest mit dem Substrat verbunden. Die Aufhängeflächen 30 befinden sich in dem Ausführungsbeispiel der Figur 5 unmittelbar auf der Hilfsschicht 2. Die Aufhängeflächen können aber auch auf anderen Teilen des Substrates oder einer darauf aufgebrachten Schichtstruktur befestigt sein. Bei dem Beispiel der Figur 7 sind acht Aufhängeflächen 30 vorhanden, die jeweils über eine Verstrebung 29 mit einer Ecke des beweglichen Elementes 28 verbunden sind. An jeder Ecke des Elementes 28 enden zwei dieser Verstrebungen, die geradlinig jeweils in einer von zwei zueinander senkrechten Richtungen ausgerichtet sind. Diese Aufhängung des beweglichen Elementes ist relativ steif und führt dazu, daß sich das Element 28 bei einer Auslenkung senkrecht zur Zeichenebene relativ stark durchbiegt.

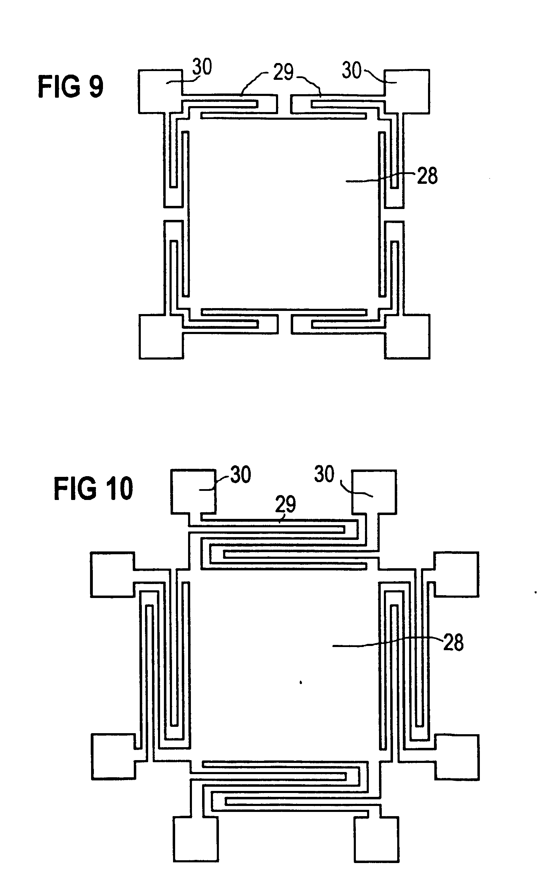

Demgegenüber stellt die Struktur, die in Figur 8 dargestellt ist, eine Verbesserung dar. Die Verstrebungen 29 sind hier als Mäander mit jeweils zwei parallel zum Rand des Elementes 28 geführten Abschnitten strukturiert. Bei entsprechender Wahl des Abstandes zwischen den Aufhängeflächen 30 und dem beweglichen Element 28 kann auf diese Weise eine Aufhängung des Elementes erreicht werden, die ein Durchbiegen des Elementes weitgehend verhindert. Die Verstrebungen münden auch hier an den Ecken des Elementes 28. Bei dem Ausführungsbeispiel der Figur 9 ist gezeigt, wie sich die Ausführungsform nach Figur 8 mit nur vier Aufhängeflächen 30 realisieren läßt. Es ist dann allerdings der Abstand zwischen dem beweglichen Element und den Aufhängeflächen bereits durch den Abstand der Teile der Verstrebungen voneinander festgelegt. Die Freiheitsgrade bei der Anpassung der Abmessungen sind daher gegenüber der Struktur nach Figur 8 etwas eingeschränkt.

Eine weitergehende Ausgestaltung ergibt sich entsprechend der Figur 10, bei der durch einen größeren Abstand zwischen den Aufhängeflächen und dem beweglichen Element ermöglicht ist, die parallel zu den Rändern des beweglichen Elementes geführten Anteile der Verstrebungen 29 wesentlich länger auszubilden, was zu einer weicheren Aufhängung des Elementes führt.

Die mäandrierten Verstrebungen der Beispiele der Figuren 8 bis 10 haben den Vorteil, daß ein in der Strukturschicht auftretender homogener Stress entspannt wird und die Empfindlichkeit des Sensors gegen Beschleunigungen in der Zeichenebene minimiert wird. Außerdem wird der Platzbedarf der Verstrebungen verringert. Die Befestigung der Verstrebungen 29 an den Ecken des beweglichen Elementes 28 hat unter anderem den Vorteil, daß der den Hohlraum 19 umgebende Steg 11 nur an den Ecken unterbrochen zu werden braucht und daher eine wirkungsvolle Schutzwand für den Ätzprozeß darstellen kann. Das bewegliche Element kann außerdem an die Anordnung der Stege oder Stützen in geeigneter Weise angepaßt werden. Das Element kann in Aufsicht eine beliebige geometrische Form aufweisen und wurde nur der Einfachheit halber in den Figuren jeweils als quadratisch oder rechteckig dargestellt.

Es ist außerdem möglich, die für die Abstützung der Abdeckungsschicht vorgesehenen Stege auch im Innern des Hohlraumes vorzusehen, oder an den Wänden des Hohlraumes nur pfeilerartige Stützen anzubringen. Es kann z. B. genügen, wenn bei einem länglich ausgestalteten beweglichen Teil die Stege 11 nur an Schmalseiten des Hohlraumes 19 vorhanden sind. Bei der Ausführungsform der Figur 4 können z. B. die drei Stützen 12, die auf der rechten Seite hintereinander auf einer Geraden liegend eingezeichnet sind, durch einen durchgehenden Steg 11 ersetzt werden. Eine Abdeckungsschicht 15 aus Metall kann z. B. so strukturiert werden, daß zusätzlich zu dem in den Figuren eingezeichneten Anteil ein als Anschlußkontakt vorgesehener Anteil dieser Abdeckungsschicht 15 außerhalb des in Figur 4 dargestellten Bereiches vorhanden ist. Die erste Metallisierungsebene kann auch so strukturiert werden, daß z. B. die dadurch gebildete Abdeckungsschicht 15 lateral in Leiterbahnen übergeht.

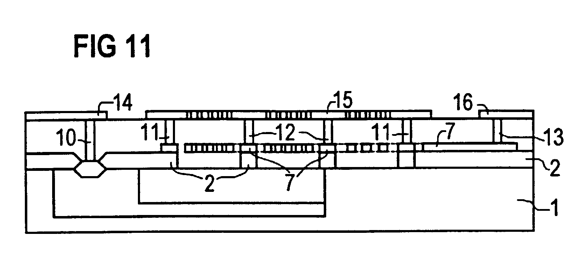

Figur 11 zeigt eine alternative Ausgestaltung des Sensors, bei der die Stege 11 und Stützen 12 nicht auf dem Halbleitermaterial des Substrates oder einer darauf aufgebrachten Schichtstruktur ruhen, sondern auf jeweils noch vorhandenen Anteilen der Strukturschicht 7. Diese Ausführungsform wird z. B. hergestellt, indem die Hilfsschicht 2 nur in den für elektrischen Anschluß vorgesehenen Kontaktbereichen 5 ausgespart bleibt. Die Strukturschicht 7 wird auf eine durchgehende Oberfläche der Hilfsschicht 2 aufgebracht und strukturiert. Bei dieser Strukturierung bleiben jeweils an den Stellen, an denen Stege 11 oder Stützen 12 vorgesehen sind, von dem Rest der Strukturschicht 7 separierte kleine Anteile stehen. Diese Anteile sind also von dem beweglichen Element 8, den Verstrebungen 9 und dem restlichen für eine Verankerung des Elementes auf dem Substrat vorgesehenen Anteil der Strukturschicht 7 getrennt. Der Hohlraum unter der wie beschrieben herzustellenden Abdeckungsschicht 15 wird dann selektiv zu dem Material der Abdeckungsschicht 15 und dem Material der Strukturschicht 7 ausgeätzt, wobei allerdings die Dauer der Ätzung so begrenzt wird, daß von der Hilfsschicht 2 unterhalb der Stege 11 bzw. Stützen 12 ausreichend große Restanteile stehenbleiben. Die Stützen 12 werden also in dem in Figur 11 dargestellten Beispiel gebildet durch einen unteren restlichen Anteil der Hilfsschicht 2, einen darauf befindlichen isolierten Anteil der Strukturschicht 7 und die entsprechend dem Ausführungsbeispiel von Figur 5 gestalteten oberen Anteile, die z. B. entsprechend einer Kontaktlochauffüllung aus Metall gebildet werden können. Das Ausätzen des Hohlraumes kann auch hier entsprechend der Figur 3 bereits nach der Herstellung der Abdeckungsschicht oder erst am Ende des Gesamtprozesses entsprechend der Figur 6 erfolgen. Die isolierten Anteile der Strukturschicht 7, die einen Teil der Stützen 12 bilden, müssen ggf. so bemessen werden, daß die Dauer des Ätzprozesses ausreichend unkritisch bleibt, um ein zu weit gehendes Entfernen der Hilfsschicht 2 unterhalb dieser Anteile und damit eine unzureichende mechanische Stabilität der Abstützung der Abdeckungsschicht zu vermeiden. Bei alternativen Ausführungsformen können auch hier die dotierten Bereiche im Substrat 1 weggelassen oder anders strukturiert werden.

Bei allen gezeigten Ausführungsformen ist es möglich, einen in der aufgebrachten Abdeckungsschicht 15 auftretenden Stress dadurch zu entspannen, daß zusätzlich zu den für das Herstellen des Hohlraumes vorgesehenen Ätzlöchern (s. z. B. Figur 2, Ätzlöcher 17) weitere Aussparungen oder Löcher in der Abdeckungsschicht 15 hergestellt werden, die bei Bedarf durch die nachträglich aufzubringende Verschlußschicht oder eine Passivierung der Oberfläche abgedeckt werden können. Bei Realisierung eines Drucksensors entsprechend der vorliegenden Erfindung bleiben diese Öffnungen in der Abdeckungsschicht offen, um ein Einwirken des äußeren, zu messenden Druckes auf das Sensorelement zu ermöglichen. Die Abdeckungsschicht kann bei alternativen Ausführungsformen als Bestandteil der zweiten oder höheren Metallisierungsebene hergestellt werden, falls trotz des großen Abstandes zum Substrat eine ausreichende mechanische Stabilität der Stützen erreicht werden kann.

## Patentansprüche

1. Verfahren zur Herstellung eines mikromechanischen Halbleiterbauelementes mit einem beweglichen Element (8), bei dem
a) an einer Oberseite eines Substrates (1) eine Hilfsschicht (2) aus einem für den nachfolgenden Schritt g geeigneten Material hergestellt wird,
b) eine für das bewegliche Element vorgesehene Strukturschicht (7) aufgebracht und unter Verwendung einer Maske strukturiert wird,
c) eine weitere Hilfsschicht (20) aus einem für den nachfolgenden Schritt g geeigneten Material diese Strukturschicht überdeckend aufgebracht wird,
d) für Kontakte und für vorgesehene pfeilerartige Stützen (12) oder Stege (11) Öffnungen in dieser weiteren Hilfsschicht unter Verwendung einer Maske hergestellt werden,
e) diese Öffnungen mit Material aufgefüllt werden,
f) eine Abdeckungsschicht (15) abgeschieden wird, so daß sie einen für das bewegliche Element vorgesehenen Bereich überdeckt, und diese Abdeckungsschicht mit Ätzlöchern (17) versehen wird,
g) unter Verwendung von jeweils in Schritt b und in Schritt f hergestellten Ätzlöchern in der Abdeckungsschicht und in der Strukturschicht das Material der Hilfsschicht und der weiteren Hilfsschicht soweit entfernt wird, daß der für das bewegliche Element vorgesehene Teil der Strukturschicht die vorgesehene Beweglichkeit aufweist und das in Schritt e in die Öffnungen gefüllte Material als Stützen (11, 12) für die Abdeckungsschicht übrigbleibt.

2. Verfahren nach Anspruch 1, bei dem in Schritt d Öffnungen so hergestellt werden, daß sich in den Schritten e und g Stege (11) an lateralen Wänden eines in Schritt g hergestellten Hohlraumes (19) ergeben.

3. Verfahren nach Anspruch 1 oder 2, bei dem in Schritt e Metall verwendet wird.

4. Verfahren nach einem der Ansprüche 1 bis 3, bei dem in Schritt f Metall verwendet wird.

5. Verfahren nach einem der Ansprüche 1 bis 4, bei dem in Schritt a die Hilfsschicht (2) so hergestellt wird, daß jeder Bereich einer in Schritt d herzustellenden Öffnung von dieser Hilfsschicht frei bleibt.

6. Verfahren nach einem der Ansprüche 1 bis 4, bei dem
in Schritt d die Öffnungen nur in der weiteren Hilfsschicht (20) hergestellt werden und
in Schritt g das Material der Hilfsschicht(2) ausgeätzt wird,
wobei die Dauer der Ätzung so begrenzt wird, daß von der Hilfsschicht (2) unterhalb der Stege (11) bzw. Stützen (12) ausreichend große Restanteile stehenbleiben.

7. Verfahren nach einem der Ansprüche 1 bis 6, bei dem in Schritt a ein Substrat (1) aus Silizium verwendet wird und die Hilfsschicht (2) durch lokale Oxidation des Siliziums hergestellt wird.

8. Verfahren nach einem der Ansprüche 1 bis 7, bei dem in Schritt e Wo oder AlSiCu verwendet wird.

9. Verfahren nach einem der Ansprüche 1 bis 8, bei dem in Schritt b zwischen vier Stellen am Rand eines für das bewegliche Element (28) vorgesehenen Anteiles der Strukturschicht (7) und einem restlichen für die Verankerung des Elementes auf dem Substrat (1) vorgesehenen Anteil (30) der Strukturschicht Verstrebungen (29) strukturiert werden.

10. Verfahren nach einem der Ansprüche 1 bis 9, bei dem in Schritt b zwischen einem für das bewegliche Element vorgesehenen Anteil (28) und einem restlichen für die Verankerung des Elementes auf dem Substrat vorgesehenen Anteil (30) der Strukturschicht mäandrierende Verstrebungen (29) strukturiert werden.

## Claims

1. Method for fabricating a micromechanical semiconductor device having a movable element (8), in which
a) an auxiliary layer (2) is fabricated on an upper side of a substrate (1) from a material which is suitable for the following step g,
b) a structure layer (7) which is provided for the movable element is applied and is structured using a mask,
c) a further auxiliary layer (20), made of a material which is suitable for the following step g, is applied to this structure layer so as to cover it,
d) using a mask, openings are fabricated in this further auxiliary layer for contacts and for proposed pillar-like supports (12) or webs (11),
e) these openings are filled with material,
f) a covering layer (15) is deposited, so that it covers a region which is provided for the movable element, and this covering layer is provided with etching holes (17),
g) using etching holes which are respectively fabricated in the covering layer and in the structure layer in step b and in step f, the material of the auxiliary layer and of the further auxiliary layer is removed to such an extent that the part of the structure layer which is proposed for the movable element has the proposed mobility, and the material filled into the openings in step e remains as supports (11, 12) for the covering layer.

2. Method according to Claim 1, in which, in step d, openings are fabricated in such a way that webs (11) on lateral walls of a cavity (19) fabricated in step g are produced in steps e and g.

3. Method according to Claim 1 or 2, in which metal is used in step e.

4. Method according to one of Claims 1 to 3, in which metal is used in step f.

5. Method according to one of Claims 1 to 4, in which, in step a, the auxiliary layer (2) is fabricated in such a way that each region of an opening which is to be fabricated in step d remains free of this auxiliary layer.

6. Method according to one of Claims 1 to 4, in which, in step d, the openings are fabricated only in the further auxiliary layer (20), and in step g, the material of the auxiliary layer (2) is etched away, the duration of the etching being limited to such an extent that sufficiently large residual portions of the auxiliary layer (2) remain underneath the webs (11) and/or supports (12).

7. Method according to one of Claims 1 to 6, in which, in step a, a substrate (1) made of silicon is used, and the auxiliary layer (2) is fabricated by means of local oxidation of the silicon.

8. Method according to one of Claims 1 to 7, in which Wo or AlSiCu is used in step e.

9. Method according to one of Claims 1 to 8, in which, in step b, struts (29) are structured between four points on the edge of a portion, provided for the movable element (28), of the structure layer (7), and a remaining portion (30), provided for the anchoring of the element on the substrate (1), of the structure layer.

10. Method according to one of Claims 1 to 9, in which, in step b, meandering struts (29) are structured between a portion (28), provided for the movable element, and a remaining portion, provided for the anchoring of the element on the substrate, of the structure layer.

## Revendications

1. Procédé de fabrication d'un composant semi-conducteur micromécanique comportant un élément mobile (8), dans lequel
a) sur une face supérieure d'un substrat (1) est fabriquée une couche auxiliaire (2) dans une matière appropriée pour l'étape suivante g,
b) une couche de structure (7) prévue pour l'élément mobile est appliquée et est structurée en utilisant un masque,
c) une autre couche auxiliaire (20) en une matière appropriée pour l'étape suivante g est appliquée en recouvrant cette couche de structure,
d) pour des contacts et pour des supports (12) ou des barrettes (11) en forme de piliers prévus, des ouvertures sont fabriquées dans cette autre couche auxiliaire en utilisant un masque,
e) ces ouvertures sont remplies d'une matière,
f) une couche de recouvrement (15) est déposée, de sorte qu'elle recouvre une zone prévue pour l'élément mobile, et cette couche de recouvrement est dotée de trous de gravure (17),
g) en utilisant des trous de gravure de la couche de recouvrement et de la couche de structure, fabriqués à chaque fois à l'étape b et à l'étape f, la matière de la couche auxiliaire et de l'autre couche auxiliaire sont enlevées jusqu'à ce que la partie, de la couche de structure, prévue pour l'élément mobile présente la mobilité prévue et jusqu'à ce que la matière remplie à l'étape e dans les ouvertures subsiste comme supports (11, 12) pour la couche de recouvrement.

2. Procédé selon la revendication 1, dans lequel des ouvertures sont fabriquées à l'étape d de sorte que des barrettes (11) sont obtenues aux étapes e et g sur les parois latérales d'une cavité (19) fabriquée à l'étape g.

3. Procédé selon la revendication 1 ou 2, dans lequel du métal est utilisé à l'étape e.

4. Procédé selon l'une des revendications 1 à 3, dans lequel du métal est utilisé à l'étape f.

5. Procédé selon l'une des revendications 1 à 4, dans lequel à l'étape a, la couche auxiliaire (2) est fabriquée de telle manière que chaque zone d'une ouverture, à fabriquer à l'étape d, reste libre de cette couche auxiliaire.

6. Procédé selon l'une des revendications 1 à 4, dans lequel, à l'étape d, les ouvertures ne sont fabriquées que dans l'autre couche auxiliaire (20) et, à l'étape g, la matière de la couche auxiliaire (2) est attaquée, la durée de l'attaque étant limitée de telle sorte que des fractions résiduelles suffisamment grandes de la couche auxiliaire (2) subsistent au-dessous des barrettes (11) resp. des supports (12).

7. Procédé selon l'une des revendications 1 à 6, dans lequel un substrat (1) de silicium est utilisé à l'étape a et la couche auxiliaire (2) est fabriquée par oxydation locale du silicium.

8. Procédé selon l'une des revendications 1 à 7, dans lequel du Wo ou de l'AlSiCu est utilisé à l'étape e.

9. Procédé selon l'une des revendications 1 à 8, dans lequel, à l'étape b, des entretoisements (29) sont structurés entre quatre endroits situés au bord d'une fraction, prévue pour l'élément mobile (28), de la couche de structure (7) et une fraction résiduelle (30) de la couche de structure (7), prévue pour l'ancrage de l'élément sur le substrat (1).

10. Procédé selon l'une des revendications 1 à 9, dans lequel, à l'étape b, des entretoisements (29) décrivant des méandres sont structurés entre une fraction (28) prévue pour l'élément mobile et une fraction résiduelle (30) de la couche de structure, prévue pour l'ancrage de l'élément sur le substrat.
